Europäisches Patentamt

European Patent Office

Office européen des brevets

(19)

(11) EP 0 614 232 B1

(12) FASCICULE DE BREVET EUROPEEN

(45) Date de publication et mention
de la délivrance du brevet:
06.08.1997 Bulletin 1997/32

(51) Int Cl.6: H01L 29/866

(21) Numéro de dépôt: 94410011.4

(22) Date de dépôt: 28.02.1994

(54) **Diode de référence dans un circuit intégré bipolaire**

Referenzdiode in integriertem Bipolarschaltkreis

Reference diode in bipolar integrated circuit

(84) Etats contractants désignés:
DE FR GB IT

(30) Priorité: 01.03.1993 FR 9302617

(43) Date de publication de la demande:
07.09.1994 Bulletin 1994/36

(73) Titulaire: SGS-THOMSON MICROELECTRONICS
S.A.
94250 Gentilly (FR)

(72) Inventeurs:
• Le Roux, Gérard
F-38700 le Sappey-en-Chartreuse (FR)
• Le Menn, Jacques
F-38000 Grenoble (FR)

(74) Mandataire: de Beaumont, Michel
1bis, rue Champollion
38000 Grenoble (FR)

(56) Documents cités:
EP-A- 0 017 022        EP-A- 0 232 589
EP-A- 0 314 399        EP-A- 0 521 802
US-A- 4 651 178

• PATENT ABSTRACTS OF JAPAN, vol. 10, no. 19
(P-423) 24 Janvier 1986; & JP-A-60 171 515

## Description

La présente invention concerne le domaine des circuits intégrés bipolaires, et plus particulièrement la réalisation de diodes à avalanche destinées à servir de référence de tension dans de tels circuits.

Les diodes à avalanche ont été longuement étudiées, et l'on sait, quand on réalise des composants discrets, obtenir des diodes à avalanche satisfaisantes. Néanmoins, dans le cadre de la réalisation d'un circuit intégré, de nombreuses contraintes sont imposées, à savoir que l'on réalise simultanément un grand nombre de composants élémentaires et que tous ces composants doivent être réalisés en recourant à un minimum d'étapes technologiques.

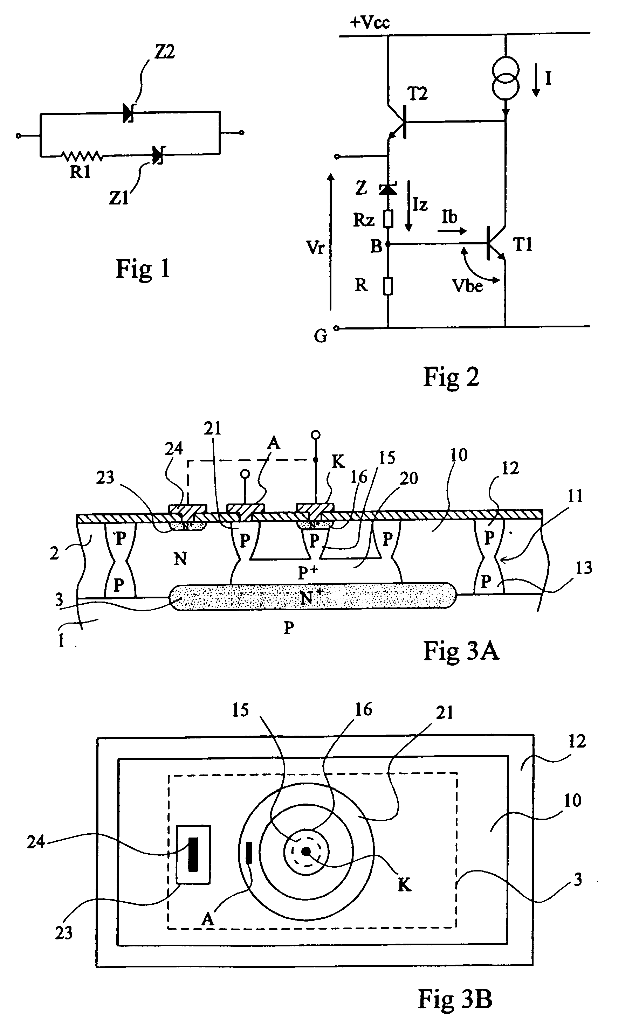

Ainsi, de façon générale, quand on cherche à réaliser une diode à avalanche enterrée et isolée du substrat, Z, on obtient en fait un composant dont le schéma équivalent est illustré en figure 1. Ce composant comprend une première diode à avalanche Z1 en série avec une résistance R1. Une deuxième diode Z2 est disposée en parallèle sur l'ensemble en série de la diode Z1 et de la résistance R1.

En pratique, la résistance R1 a souvent une valeur non négligeable, par exemple de l'ordre de 400 à 1000 $\Omega$. D'autre part, normalement, la diode Z2 a un seuil d'avalanche plus élevé que celui de la diode Z1 et n'intervient pas. Toutefois, quand le courant d'avalanche dans la diode Z1 augmente, la chute de tension dans la résistance R1 croit et quand cette chute de tension dépasse la différence de tensions d'avalanche entre les diodes Z2 et Z1, la diode Z2 peut à son tour entrer en avalanche.

On peut éviter ces divers inconvénients en prévoyant des niveaux de dopage spécifiques pour les différentes couches constituant la diode à avalanche mais alors on complique le processus technologique de fabrication et l'on ne peut plus utiliser une filière classique de fabrication de composant bipolaire.

On connait des diodes à avalanche telles que décrites dans les demandes de brevet européen EP-A-0314399 et EP-A-0017022 qui présentent l'avantage que la diode parasite Z2 a une tension d'avalanche très élevée, de l'ordre de 100 volts ou plus, tandis que la diode Z1 a une tension d'avalanche de l'ordre de 6 V. Ainsi, la diode parasite Z2 n'intervient plus.

En dépit de cet avantage, ces diodes présentent encore certains inconvénients. Comme on l'a souligné précédemment, leur processus de fabrication doit utiliser uniquement des étapes qui sont déjà utilisées dans la fabrication d'un circuit intégré bipolaire classique. Ainsi, les niveaux de dopage des diverses couches de ces diodes sont imposés par la technologie et ne sont pas optimisés. Il en résulte que la résistance série R1 de la diode peut être de l'ordre de 100 à 400 ohms. De plus, la diode présente un coefficient de température, c'est-à-dire une variation de sa tension de claquage en fonction de la température, qui est de l'ordre de 2,8 mV/°C. Ces deux caractéristiques (résistance interne et coefficient de température non négligeable) constituent des inconvénients notables pour la réalisation d'une diode de référence dont on voudrait que la tension soit définie avec précision quels que soient le courant qui la traverse et la température du circuit intégré.

Etant donné que ces deux inconvénients existent à plus ou moins grande échelle dans toutes les diodes à avalanche connues, on a prévu dans l'art antérieur de former à partir d'une diode à avalanche des circuits de fourniture de tension de référence compensée en courant et en température. Un exemple d'un tel circuit est illustré en figure 2. Ce circuit est connecté aux bornes d'une tension d'alimentation, par exemple entre une alimentation positive Vcc et la masse G. Dans ce circuit, une première branche est constituée de la connexion en série d'une source de courant I et d'un transistor NPN T1. Une deuxième branche comprend la connexion en série d'un transistor NPN T2, d'une diode à avalanche (représentée sous forme d'une diode à avalanche pure Z en série avec une résistance interne RZ) et d'une résistance R. La base du transistor T2 est connectée au collecteur du transistor T1 et la base du transistor T1 est connectée au point de raccordement entre la diode à avalanche Z-RZ et la résistance R. La tension de référence recherchée Vr est prise aux bornes de la connexion en série de la diode à avalanche et de la résistance R, c'est-à-dire entre l'émetteur du transistor T2 et la masse G. Si on appelle Vbe la tension base-émetteur du transistor T1, la tension de référence est donnée par l'expression ci-dessous :

$$Vr = Vz + Vbe + RzIz,$$

Iz étant le courant traversant la diode à avalanche.

Le courant de base du transistor T1 étant faible, par rapport au courant Iz, on peut écrire :

$$Iz = Vbe/R,$$

d'où :

$$Vr = Vz + Vbe + Vbe(Rz/R)$$

soit :

$$Vr = Vz + Vbe(1 + Rz/R).$$

On voit que la tension de référenoe dépend du rapport entre la résistance série Rz de la diode à avalanche et la résistance R qui définit le courant dans cette diode. Rz n'étant généralement pas négligeable devant R, la valeur absolue de la tension de référence sera soumise aux variations du rapport Rz/R et il en sera de même pour la dérive en température. Il en résulte une mauvaise reproductibilité de cette tension de référence.

Ainsi, un objet de la présente invention est de prévoir une nouvelle structure de diode de référence applicable à un circuit intégré bipolaire et n'utilisant pas d'étape de fabrication autre que les étapes normalement prévues dans un circuit intégré bipolaire.

Un autre objet de la présente invention est de prévoir une diode de référence compensée en courant et en température.

Plus particulièrement, la présente invention propose une réalisation de la résistance R susmentionnée qui permet de s'assurer que le rapport Rz/R reste insensible aux dispersions de fabrication.

Pour atteindre ces objets, la présente invention prévoit une diode de référence formée dans un caisson isolé d'une couche épitaxiée d'un premier type de conductivité recouvrant un substrat du deuxième type de conductivité. Cette diode de référence comprend :

d'une part, une diode à avalanche comportant, au fond du caisson, une région profonde du deuxième type de conductivité à haut niveau de dopage, sous et en débordement de laquelle est formée une couche enterrée du premier type de conductivité ; une première diffusion profonde du deuxième type de conductivité rejoignant une partie centrale de ladite région profonde ; une deuxième diffusion profonde du deuxième type de conductivité rejoignant la périphérie de ladite région profonde ; une région superficielle du premier type de conductivité à haut niveau de dopage recouvrant la surface de la première diffusion profonde et formant avec elle une jonction à avalanche ; une première électrode en contact avec la surface de la région superficielle ; et une deuxième électrode en contact avec la surface de la deuxième diffusion profonde ;

d'autre part, dans le même caisson, au moins une autre structure identique à celle de cette diode à l'exclusion de la région superficielle du premier type de conductivité, la première électrode étant en contact avec la surface supérieure de la première diffusion profonde, cette autre structure formant entre ses première et deuxième électrodes une résistance ; et des moyens de connexion en série de la diode et de la ou des résistances.

Selon un mode de réalisation de la présente invention, la deuxième diffusion profonde a une forme annulaire.

Selon un mode de réalisation de la présente invention, l'isolement du caisson est assuré par la rencontre d'une fondation du deuxième type de conductivité formée dans le substrat et d'une troisième diffusion profonde du deuxième type de conductivité partant de la surface externe de la couche épitaxiée, et ladite région profonde est de même nature que ladite fondation.

La présente invention prévoit aussi un circuit de fourniture de tension de référence comportant une telle diode de référence et comprenant, entre une source d'alimentation haute et la masse, une première branche constituée de la connexion en série d'une source de courant et d'un premier transistor, une deuxième branche comprenant la connexion en série d'un deuxième transistor, de la diode à avalanche et de la ou des résistances susmentionnées, des moyens de connexion entre la base du deuxième transistor et l'émetteur du premier, des moyens de connexion entre la base du premier transistor et le point de connexion de la diode à avalanche et de la ou des résistances.

Ces objets, caractéristiques et avantages ainsi que d'autres de la présente invention seront exposés en détail dans la description suivante d'un mode de réalisation particulier faite en relation avec les figures jointes parmi lesquelles :

la figure 1 représente un schéma équivalent d'une diode à avalanche enterrée et isolée classique ;
la figure 2 représente un montage classique de fourniture de tension de référence ;
les figures 3A et 3B représentent une vue en coupe et une vue de dessus d'un mode de réalisation d'une diode à avalanche utilisable dans la présente invention ;
les figures 4A et 4B représentent une vue en coupe et une vue de dessus d'une diode à avalanche combinée à des résistances pour former une diode de référence selon la présente invention ; et
la figure 5 est un circuit de fourniture de tension de référence selon la présente invention comprenant une diode de référence incorporant la structure des figures 4A et 4B.

Conformément à l'usage dans le domaine de la représentation des composants semiconducteurs, ces diverses figures sont fortement schématiques et ne sont pas dessinées à l'échelle. Notamment, les formes courbes des bords de jonction résultant des diffusions ne correspondent pas à la réalité.

Comme le représentent les figures 3A et 3B, la présente invention utilise une diode à avalanche formée dans un circuit de technologie bipolaire comprenant une couche épitaxiée 2 de type N recouvrant un substrat 1 de type P. Plus particulièrement, la diode est formée dans un caisson 10 de la couche épitaxiée 2 délimité latéralement par un mur d'isolement de type P 11 et dont le fond correspond à une couche enterrée 3 de type N. Le mur d'isolement 11 est constitué par la rencontre d'une diffusion profonde 12 descendant à partir de la surface de la couche épitaxiée 2 et d'une diffusion 13 montant à partir d'une fondation de type P initialement formée à la surface du substrat 1 avant la réalisation de la couche épitaxiée 2.

La jonction active de la diode est formée de la jonction entre une diffusion profonde descendante de type P 15 et une région superficielle de type N fortement dopée 16. La région 16, en dehors de sa jonction avec la diffusion P 15 est entourée d'une région de type N faiblement dopée correspondant à la couche épitaxiée.

Le contact avec la région $N^+$ 16 est repris par une métallisation de cathode K. Le contact avec la région P 15 est repris par une diffusion profonde de type P fortement dopée 20 correspondant à une diffusion ascendante formée à partir d'une fondation de type P implantée dans le substrat au-dessus de la couche enterrée 3 de type $N^+$. Cette fondation P est formée en même temps que les fondations des diffusions ascendantes d'isolement 13. Ensuite, des diffusions profondes 21 sont formées à partir de la surface de la couche épitaxiée et rejoignent la couche profonde 20. Les diffusions 21 sont formées en même temps que les diffusions 12 et 15. Une métallisation d'anode A permet de reprendre un contact avec la partie supérieure de la diffusion 21.

De plus, de façon classique, comme chaque fois que l'on réalise dans un circuit intégré bipolaire un composant dans un caisson, ce caisson est polarisé pour être isolé par jonction du substrat. Ainsi, le caisson N 10 doit être polarisé positivement. Ceci est réalisé en formant une région 23 à haut niveau de dopage de type N dans une portion de la surface supérieure du caisson 10, cette région étant en contact avec une métallisation 24 qui est reliée à un potentiel plus positif que celui auquel est connecté le substrat 1. La diode fonctionnant en diode à avalanche, sa borne K est normalement à un potentiel plus positif que sa borne A et la métallisation 24 peut être reliée à la borne K.

La figure 3B représente une vue de dessus schématique correspondant à la figure 3A et de mêmes parties qu'en figure 3A sont désignées par de mêmes références. On notera que la région 21 de reprise de contact avec la couche profonde 20 est de préférence une région circulaire entourant complètement la région $N^+$ 16 de cathode.

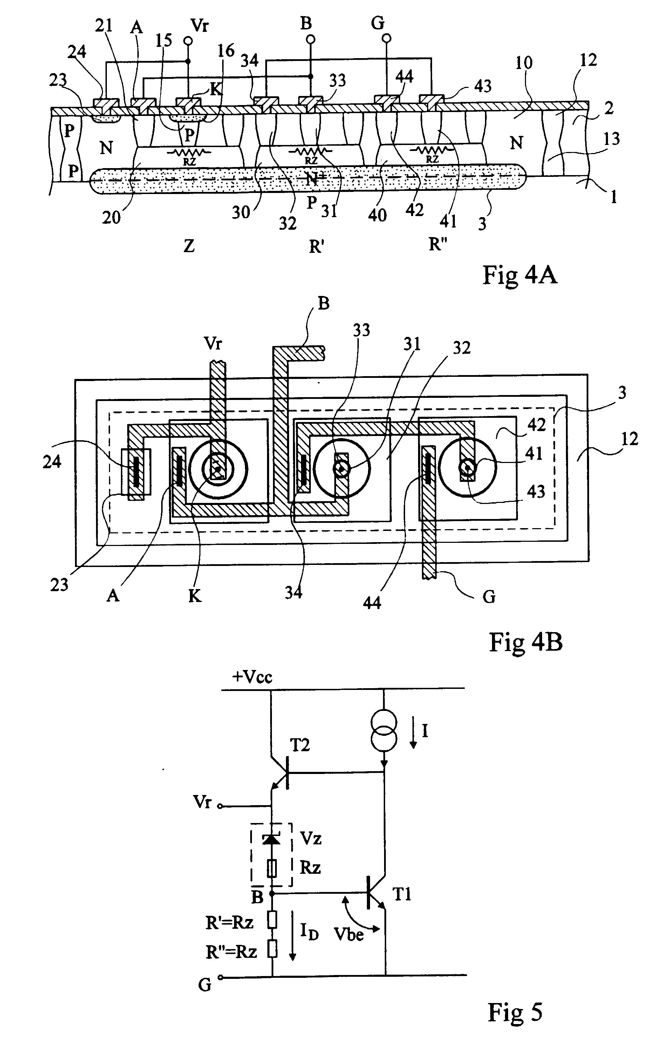

Les figures 4A et 4B représentent en coupe et en vue de dessus, respectivement, une association selon la présente invention de la diode à avalanche décrite précédemment et de résistances destinées à constituer la résistance R décrite en relation avec la figure 2. Dans ces figures, de mêmes éléments qu'en figures 3A et 3B sont désignés par de mêmes références.

On retrouve à la partie gauche de la figure 4A une structure de diode strictement identique à celle de la figure 3A. Dans l'exemple de la figure 4A, cette structure de diode est répétée deux fois, en omettant la diffusion $N^+$ 16, pour former deux structures de résistances R' et R'' ayant sensiblement la même valeur de résistance Rz que la diode. La résistance R' comprend une couche profonde 30, une diffusion profonde centrale 31 rejoignant la couche profonde 30 et une diffusion profonde 32 en anneau rejoignant également cette couche profonde. Un contact 33 est pris avec la région 31 et un contact 34 avec la surface de l'anneau 32. De même, la deuxième résistance R'' comprend des régions correspondantes 40, 41, 42, 43 et 44. La borne A de la diode est reliée à la métallisation 33 de la résistance R' et à la borne de base B du transistor T1. La métallisation 34 de la résistance R' est reliée à la métallisation 43 de la résistance R'' dont la métallisation 44 est reliée à la borne de masse G.

La vue de dessus de la figure 4B permet de mieux voir les diverses métallisations.

La figure 5 reprend le schéma de la figure 2 avec indication des résistances R' et R'' ayant toutes deux la même valeur Rz que la résistance série de la diode Vz.

Avec cette structure, on a

$$Vr = Vz + Vbe[1 + Rz/(R' + R'')]$$

$$= Vz + Vbe(1 + Rz/2Rz)$$

$$= Vz + 1{,}5\ Vbe.$$

On notera d'ailleurs que l'on aurait pu prévoir une seule résistance R ou plus de deux résistances R. Néanmoins, pour réduire la dérive en température, on préfère dans le cas de la technologie utilisée prévoir deux résistances R'.

En effet, la dérive en température est alors :

$$dVr/dT = dVz/dT + 1,5\ dVbe/dT.$$

Dans la technologie utilisée $dVz/dT = +2,8$ mV/°C et $dVbe/dT = -2$ mV/°C. On arrive donc à :

$$dVr/dT = -0,2\ mV/°C,$$

c'est-à-dire que la dérive en température est pratiquement complètement compensée. Cette compensation peut être rendue rigoureuse en choisissant l'intensité de la source de courant I en fonction de la surface du transistor T1 pour obtenir une densité de courant déterminée dans ce transistor. En effet le coefficient de température de la tension Vbe diminue lorsque la densité de courant dans l'émetteur du transistor T1 augmente.

Bien entendu, la présente invention est susceptible de diverses variantes qui apparaîtront à l'homme de l'art. Notamment, alors que l'on a représenté en vue de dessus une structure de forme circulaire avec une électrode de cathode centrale et une électrode d'anode annulaire, cette structure pourrait avoir toute autre forme souhaitée. Par exemple les diverses régions pourraient être des régions carrées emboîtées les unes dans les autres, des régions rectangulaires, des régions digitées etc.

A titre d'exemple de valeurs numériques, l'épaisseur de la couche épitaxiée 2 peut être de l'ordre de 16 μm. La profondeur de diffusion des diffusions profondes 12, 21, 31, 32, 41, 42 peut être de l'ordre de 6 μm, la diffusion 15 présentant un niveau de dopage au niveau de son interface avec la région N 16 de l'ordre de $3.10^{18}$ atomes/cm$^3$, cette région N 16 présentant un niveau de dopage de l'ordre de $3.10^{20}$ atomes/cm$^3$. Les couches profondes 20, 30, 40 et 13 peuvent résulter d'une implantation de bore avec une dose de $2,5\ 10^{14}$ atomes/cm$^2$ sous une énergie de 180 keV.

En se reportant aux figures 4A et 4B, dans une réalisation particulière, les zones 15, 31 et 41 ont un diamètre inférieur à 10 μm, les zones 21, 32 et 42 ont un diamètre de 48 μm, le contour extérieur de ces zones est un carré de 76 μm de côté, la zone 16 a un diamètre de 10 μm. La tension d'avalanche Vz est de 6,7 V ± 250 mV et la résistance série Rz est de 350 Ω. La tension de référence Vr obtenue (figure 6) est de 7,9 V ± 300 mV.

La présente invention est susceptible de modifications qui apparaîtront à l'homme de l'art. Notamment, certains aspects de réalisation ont été représentés de façon simplifiée. En pratique, de nombreuses améliorations usuelles seront adoptées. Par exemple, la surface supérieure de différentes couches telles que les couches 21, 31, 32, 41, 42 sera surdopée pour améliorer les contacts.

**Revendications**

1. Diode de référence formée dans un caisson isolé (10) d'une couche épitaxiée (2) d'un premier type de conductivité recouvrant un substrat (1) du deuxième type de conductivité, comprenant :

   - une diode à avalanche comportant :

     au fond du caisson, une région profonde (20) du deuxième type de conductivité à haut niveau de dopage, sous et en débordement de laquelle est formée une couche enterrée (3) du premier type de conductivité, une première diffusion profonde (15) du deuxième type de conductivité rejoignant une partie centrale de ladite région profonde,
     une deuxième diffusion profonde (21) du deuxième type de conductivité rejoignant la périphérie de ladite région profonde,
     une région superficielle (16) du premier type de conductivité à haut niveau de dopage recouvrant la surface de la première diffusion profonde et formant avec elle une jonction à avalanche,
     une première électrode (K) en contact avec la surface de la région superficielle, et
     une deuxième électrode (A) en contact avec la surface de la deuxième diffusion profonde ; et

   - caractérisée en ce qu'elle comprend en outre :

     au moins une autre structure (30-34 ; 40-44) identique à celle de ladite diode à avalanche à l'exclusion de la région superficielle du premier type de conductivité, la première électrode (33 ; 43) de cette autre structure étant alors en contact avec la surface supérieure de la première diffusion profonde (31 ; 41), cette autre structure formant entre ses première et deuxième électrodes (33, 34 ; 43, 44) une résistance, et

EP 0 614 232 B1

des moyens de connexion en série de la diode à avalanche et de la ou des résistances.

2. Diode de référence selon la revendication 1, caractérisée en ce que le premier type de conductivité est le type P et le deuxième type de conductivité est le type N.

3. Diode de référence selon la revendication 1, caractérisée en ce que la deuxième diffusion profonde (21) a une forme annulaire.

4. Diode de référence selon la revendication 1, caractérisée en ce que l'isolement du caisson est assuré par la rencontre d'une fondation (13) du deuxième type de conductivité implantée dans le substrat et d'une troisième diffusion profonde (12) du deuxième type de conductivité partant de la surface externe de la couche épitaxiée, et en ce que ladite région profonde (20) est de même nature que ladite fondation (13).

5. Circuit de fourniture de tension de référence, caractérisé en ce qu'il comprend entre une source d'alimentation haute et la masse :

une première branche constituée de la connexion en série d'une source de courant (I) et d'un premier transistor (T1),
une deuxième branche comprenant la connexion en série d'un deuxième transistor (T2) et de la diode de référence comprenant la diode à avalanche et la ou les résistances selon la revendication 1,
des moyens de connexion entre la base du deuxième transistor et l'émetteur du premier, et
des moyens de connexion entre la base du premier transistor et le point de connexion de la diode à avalanche et de la ou des résistances.

**Patentansprüche**

1. Referenzdiode, welche in einer isolierten Mulde (10) einer Epitaxieschicht (2) eines ersten Leitfähigkeitstyps ausgebildet ist, welche ein Substrat (1) des zweiten Leitfähigkeitstyps bedeckt, mit einer Lavinendiode mit folgenden Merkmalen:

einem tiefen Bereich (20) des zweiten Leitfähigkeitstyps mit einem hohen Dotierungspegel auf dem Boden der Mulde, unter dem überlappend eine vergrabene Schicht (3) des ersten Leitfähigkeitstyps ausgebildet ist, einem ersten tiefen Diffusionsbereich (15) des zweiten Leitfähigkeitstyps, der einen mittleren Teil des tiefen Bereiches berührt,
einem zweiten tiefen Diffusionsbereich (21) des zweiten Leitfähigkeitstyps, der den Umfang des tiefen Bereiches berührt,
einem Oberflächenbereich (16) des ersten Leitfähigkeitstyps mit hoher Dotierung, welcher die Oberfläche des ersten tiefen Diffusionsbereiches bedeckt und mit diesem einen Lavinenübergang bildet,
einer ersten Elektrode (K), welche in Kontakt mit der Oberfläche des Oberflächenbereichs ist, und
einer zweiten Elektrode (A), welche in Kontakt mit der Oberfläche des zweiten tiefen Diffusionsbereichs ist; die **gekennzeichnet** ist durch wenigstens eine weitere Struktur (30-34; 40-44), welche identisch mit der Lavinendiode ist, abgesehen von dem Oberflächenbereich des ersten Leitfähigkeitstyps, wobei die erste Elektrode (33; 43) dieser weiteren Struktur dann in Kontakt mit der Oberseite des ersten tiefen Diffusionsbereiches (31; 41) ist, wobei diese weitere Struktur zwischen ihrer ersten und ihrer zweiten Elektrode (33, 34; 43, 44) einen Widerstand bildet, und Mittel zum Verbinden der Lavinendiode mit dem oder den Widerständen.

2. Referenzdiode nach Anspruch 1, dadurch **gekennzeichnet**, daß der erste Leitfähigkeitstyp der P-Typ ist und der zweite Leitfähigkeitstyp der N-Typ ist.

3. Referenzdiode nach Anspruch 1, dadurch **gekennzeichnet,** daß der zweite tiefe Diffusionsbereich (21) eine Ringform hat.

4. Referenzdiode nach Anspruch 1, dadurch **gekennzeichnet**, daß die Isolation der Mulde durch den Kontakt eines Fundaments (13) des zweiten Leitfähigkeitstyps, welches in dem Substrat ausgebildet ist, mit einem dritten tiefen Diffusionsbereich (12) des zweiten Leitfähigkeitstyps, welcher von der Außenseite der Epitaxieschicht ausgeht, gewährleistet ist, und daß der tiefe Bereich (20) von derselben Art ist wie das Fundament (13).

**5.** Bezugsspannungsschaltung, dadurch **gekennzeichnet**, daß sie zwischen einer hohen Versorgungsquelle und Masse folgende Komponenten aufweist:

eine erste Verzweigung, die von der seriellen Verbindung einer Stromquelle (I) und eines ersten Transistors (T1) gebildet ist,
eine zweite Verzweigung, welche die serielle Verbindung eines zweiten Transistors (T2) und der Referenzdiode umfaßt, welche die Lavinendiode und den oder die Widerstände gemäß Anspruch (1) aufweist,
Mittel zum Verbinden der Basis des zweiten Transistors mit dem Emitter des ersten Transistors und
Mittel zum Verbinden der Basis des ersten Transistors mit dem Verbindungspunkt der Lavinendiode und des oder der Widerstände.

## Claims

**1.** A reference diode formed in an insulated well (10) of a first conductivity type epitaxial layer (2) that coats a substrate (1) of the second conductivity type, comprising:

- an avalanche diode including:

at the bottom of the well, a second conductivity type deep region (20) having a high doping level, beneath which is formed an overlapping buried layer (3) of the first conductivity type,
a first deep diffused region (15) of the second conductivity type contacting a central portion of said deep region,
a second deep diffused region (21) of the second conductivity type contacting the periphery of said deep region,
a highly doped surface region (16) of the first conductivity type coating the surface of the first deep diffused region and forming therewith an avalanche junction,
a first electrode (K) contacting the surface of the surface region, and
a second electrode (A) contacting the surface of the second deep diffused region (21);

- characterized in that it further comprises:
at least one additional structure (30-34; 40-44) identical to the structure of said avalanche diode but without the first conductivity type surface region, the first electrode (33; 43) of said additional structure being then in contact with the upper surface of the first deep diffused region (31; 41), said additional structure forming, between its first and second electrodes (33, 34; 43, 44), a resistor; and
means to serially connect the diode to the resistor(s).

**2.** The reference diode of claim 1, characterized in that the first conductivity type is P, and the second conductivity type is N.

**3.** The reference diode of claim 1, characterized in that said second deep diffused region (21) is annular.

**4.** The reference diode of claim 1, characterized in that the insulation of the well is ensured by the contact of a base (13) of the second conductivity type, formed in the substrate, with a third deep diffused region (12) of the second conductivity type extending from the external surface of the epitaxial layer, and wherein said deep region (20) is of the same nature as said base (13).

**5.** A reference voltage circuit, characterized in that it includes between a high supply source and ground:

a first branch formed by the serial connection of a current source (I) and a first transistor (T1),
a second branch comprising the serial connection of a second transistor (T2) and of the reference diode comprising the avalanche diode and the resistor(s) according to claim 1,
means for connecting the base of the second transistor to the emitter of the first transistor, and
means for connecting the base of the first transistor with the junction of the avalanche diode and the resistor.

Fig 1

Fig 2

Fig 3A

Fig 3B

EP 0 614 232 B1

Fig 4A

Fig 4B

Fig 5